Europäisches Patentamt

**European Patent Office** ·

**Office européen des brevets**

(19)

(11) Veröffentlichungsnummer: **0 308 677**

**A1**

(12) # EUROPÄISCHE PATENTANMELDUNG

(21) Anmeldenummer: **88113889.5**

(22) Anmeldetag: **25.08.88**

(51) Int. Cl.4: **G01R 25/04**

(30) Priorität: **25.09.87 DE 3732448**

(43) Veröffentlichungstag der Anmeldung:
**29.03.89 Patentblatt 89/13**

(84) Benannte Vertragsstaaten:
**DE FR GB IT NL**

(71) Anmelder: **Siemens Aktiengesellschaft Berlin
und München
Wittelsbacherplatz 2
D-8000 München 2(DE)**

(72) Erfinder: **Brust, Hans-Detlef
Martin-Luther-Strasse 2
D-6602 Dudweiler(DE)**

(54) **Verfahren und Vorrichtung zur Phasenmessung von Signalen an einem Messpunkt mit Hilfe eines modulierten Korpuskularstrahls.**

(57) Verfahren und Vorrichtung zur Phasenmessung von beliebigen Signalen an einem Meßpunkt, beispielsweise von Oberflächenwellen auf piezoelektrischen Substraten, bei dem man auf der Oberfläche einer piezoelektrischen Eigenschaft aufweisenden Probe Oberflächenwellen anregt. Ein Meßpunkt auf der Probenoberfläche wird durch ein stroboskopisches Verfahren mit Hilfe eines Korpuskularstrahls (PE) abgetastet und an dem jeweils beaufschlagten Meßpunkt der Probenoberfläche wird ein sekundäres elektrisches Signal (SE) über einen Detektor (DT) einer Auswerteschaltung (AS) zugeführt. Mit Hilfe einer Rückkopplung (RK) wird innerhalb der Auswerteschaltung (AS) der Phasendetektor (PD) in einem linearen Bereich seiner Ausgangskennlinie betrieben. Hierdurch ist es möglich, die Phase am Phasendetektor konstant zu halten. Durch die Rückkopplung (RK) wird entweder die Phase des Korpuskularstrahls (PE) oder des zu untersuchenden Signals, beispielsweise der Oberflächenwelle, die an dem Interdigitalwandler (IDW) erzeugt wird, beeinflußt.

FIG 1

EP 0 308 677 A1

## Verfahren und Vorrichtung zur Phasenmessung von Signalen an einem Meßpunkt mit Hilfe eines modulierten Korpuskularstrahls

Die Erfindung betrifft ein Verfahren zur Phasenmessung von Signalen an einem Meßpunkt nach dem Oberbegriff des Patentanspruchs 1 und eine Vorrichtung zur Durchführung des Verfahrens.

Elektronische Bauelemente, in denen Oberflächenwellen durch Wandlerstrukturen auf Kristalloberflächen angeregt und detektiert werden, gewinnen in der Nachrichten- und Hochfrequenztechnik zunehmend an Bedeutung. Ihre Herstellung in Planartechnologie kann sehr genau, gut reproduzierbar und verhältnismäßig preiswert erfolgen und ihr Entwurf ist mit den Methoden des Computer-Aided-Design (CAD) immer besser optimierbar. Dennoch ergeben sich für solche Bauelemente häufig nicht tolerierbare Abweichungen zwischen realisierter und geforderter Übertragungsfunktion. Da man die Ursachen dieser Abweichungen durch Messung der Übertragungsfunktion allein nicht erkennen bzw. lokalisieren kann, müssen auch die ein Wellenfeld an der Oberfläche des Bauelementes charakterisierenden Parameter, beispielsweise mit Laser- und Elektronensonden ortsaufgelöst gemessen werden. Elektronenstrahlmeßverfahren zur stroboskopischen Abbildung der Wellenfronten laufender Oberflächenwellen in modifizierten Rasterelektronenmikroskopen sind beispielsweise aus den Artikeln von H.P. Feuerbaum et al "Visualization of Traveling Surface Acoustic Waves Using a Scanning Electron Microscope" (SEM. 1980. I. S. 502-509) bzw. "Scanned Electron Beam Probe Shows Surface Acoustic Waves in Action" (Electronics. 19. Mai 1983, S. 132-136) bekannt.

Zur Verbesserung des Entwurfs von Oberflächenwellen-Bauelementen müssen immer mehr physikalische Effekte (Kantenreflexion, Beugungseffekte) in den CAD-Modellen berücksichtigt werden. Um festzustellen, welche Effekte das Übertragungsverhalten des Oberflächenwellen-Bauelements am stärksten beeinflussen bzw. zur Bestimmung der Modellparamter reicht die Abbildung des Wellenfeldes allein nicht mehr aus, so daß zusätzliche Messungen der Ausbreitungsgeschwindigkeit, der Amplitude und der Phase von Oberflächenwellen notwendig sind.

Ein wichtiger Anwendungsfall für die Messung der Phase, beispielsweise mechanischer Wellen, ist die zerstörungsfreie Werkstoffprüfung. Beim sog. SLAM (Scanning Laser Acoustic Microscope) wird in das zu untersuchende Werkstück eine mechanische Volumenwelle eingekoppelt, deren Ausbreitung im Werkstück durch eventuell vorhandene Störungen, wie Risse und Einschlüsse, beeinflußt wird. Trifft die Welle auf die Werkstückoberfläche, so verursacht sie dort einerseits eine Auslenkung der Oberfläche und kann zum anderen durch Modenkopplung auch Oberflächenwellen erzeugen. Ein Bild der Wellenverteilung auf der Oberfläche, insbesondere der Phase der Welle, läßt Rückschlüsse darauf zu, ob Störungen in dem Werkstück vorhanden sind, und falls dies der Fall ist, welcher Art diese Störungen sind. Auf diese Art und Weise ist eine zerstörungsfreie Prüfung des Werkstücks möglich.

Zur Bestimmung der Phase wurden bisher meist stroboskopische Abbildungen ausgewertet, eine Methode, die nur eine sehr geringe Genauigkeit besitzt. Neben dieser eher qualitativen Methode kann die Phase auch mit Hilfe eines Lock-In-Verstärkers als Phasendetektor gemessen werden. Herkömmliche Phasendetektoren weisen jedoch, und dazu zählt auch ein Lock-In-Verstärker, nur in einem eng begrenzten Phasenbereich eine hinreichend große Empfindlichkeit und Genauigkeit auf. Insbesondere gilt dies für alle Phasendetektoren mit $\cos \rho$ -Charakteristik. Außerdem können vorgeschaltete Filter Phasenverzerrungen und damit eine Verfälschung der Messung bewirken.

Der Erfindung liegt die Aufgabe zugrunde, ein Verfahren und eine Vorrichtung der eingangs genannten Art anzugeben, mit dem die Phase von Signalen an einem Meßpunkt schnell und sehr genau gemessen werden kann.

Diese Aufgabe wird erfindungsgemäß durch ein Verfahren nach Anspruch 1 und eine Vorrichtung nach Anspruch 10 gelöst.

Der mit der Erfindung erzielbare Vorteil besteht insbesondere darin, daß sich hiermit eine genaue Messung der Phase von Signalen an einem Meßpunkt innerhalb eines weiten Frequenzbereichs mit sehr hoher Empfindlichkeit und Genauigkeit durchführen läßt.

Die Ansprüche 2 bis 9 sind auf eine bevorzugte Ausgestaltung des erfindungsgemäßen Verfahren gerichtet, während die Ansprüche 10 bis 24 Vorrichtungen zur Durchführungen des Verfahrens betreffen.

Die Erfindung wird nachfolgend anhand der Phasenmessung von Oberflächenwellen mit Hilfe von Zeichnungen näher erläutert.
Dabei zeigen:

Figur 1 und 2 je eine Vorrichtung zur Durchführung des erfindungsgemäßen Verfahrens,

Figur 3 die Ausgangskennlinie eines Phasendetektors in Abhängigkeit von der Phase eines Eingangssignals.

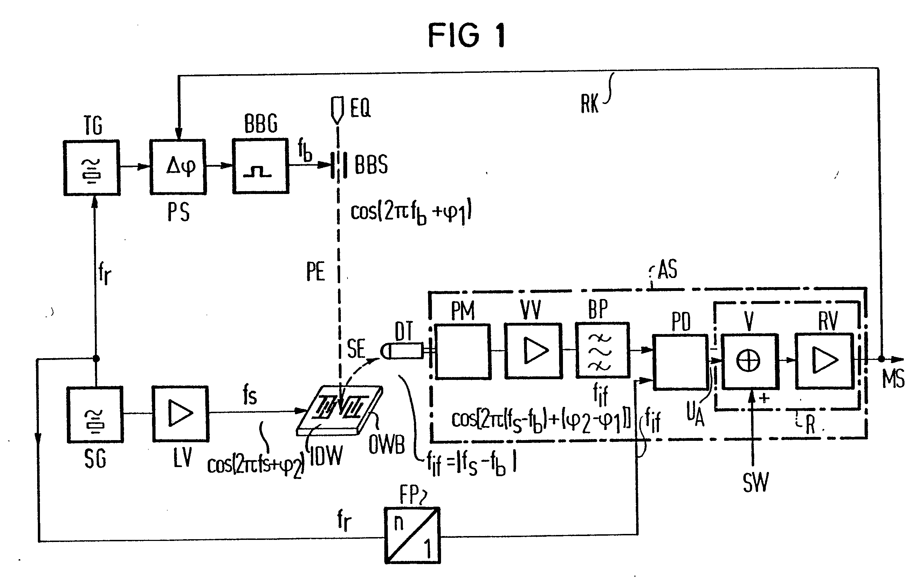

Figur 1 zeigt eine erste Vorrichtung zur Durchführung des erfindungsgemäßen Verfahrens, bei dem zu Synchronisationszwecken eine Kopplung zwischen dem Triggergenerator TG zur Ansteuerung des Beam-blanking-Generators BBG und dem Signalgenerator SG zur Ansteuerung des Interdigitalwandlers IDW vorhanden ist. Diese Synchronisation ist nicht unbedingt erforderlich, führt aber zu einer erheblich verbesserten Meßgenauigkeit. Zur Messung der Phase von Oberflächenwellen an einem Meßpunkt auf der Oberfläche eines Oberflächenwellen-Bauelementes OWB wird einer der auf dem OFW-Bauelement vorhandenen sog. Interdigitalwandler IDW zur Abstrahlung von akustischen OFW eingesetzt. Dies geschieht mit Hilfe eines Signalgenerators SG, der den Interdigitalwandler IDW über einen Leistungsverstärker LV mit einer sinusförmigen Spannung der Frequenz fs mit einer Phase $\rho_2$ anregt. Die an den Metallelektroden des Wandlers IDW anliegende Wechselspannung führt über den piezoelektrischen Effekt zur periodischen Deformation der Kristalloberfläche, die sich dann als akustische Wellen mit Geschwindigkeiten zwischen etwa 3000 m/s und 4000 m/s auf dem Oberflächenbauelement OWB ausbreiten. Die Welle dringt bis zu einer Tiefe von etwa einer Wellenlänge in den Kristall ein, wobei die Deformation der Oberfläche gewöhnlich im Bereich zwischen 0,1 und 10 Angström liegt. Dabei führt die elektromechanische Kopplung wieder über den piezoelektrischen Effekt zu lokalen Oberflächenpotentialen, die in einem Empfangswandler detektiert oder mit einem Elektronenstrahl PE mit Hilfe des Potentialkontrasteffekts abgetastet werden können. Dieser feingebündelte Primärelektronenstrahl PE wird vorzugsweise in der elektronenoptischen Säule eines modifizierten Rasterelektronenmikroskops erzeugt, die im wesentlichen eine aus Kathode, Wehnelt-Elektrode und Anode bestehende Elektronenkanone EQ, ein schnelles Strahlaustastsystem BBS und eine Reihe weiterer, in Figur 1 aus Gründen der Übersichtlichkeit nicht dargestellter magnetischer Linsen zur Strahlformung und Fokussierung des Primärelektronenstrahls PE aufweist. Der Primärelektronenstrahl PE wird über das Strahlaustastsystem BBS mit vorgeschaltetem Beam-blanking-Generator BBG mit der Frequenz $f_b$ moduliert. Dem Beam-blanking-Generator BBG vorgeschaltet ist ein steuerbarer Phasenschieber PS, mit dessen Hilfe es möglich ist, die Phase $\rho_1$ des Primärelektronenstrahls PE von außen zu steuern. Ein quarzkontrollierter Triggergenerator TG liefert das erforderliche Ansteuersignal, das über den Phasenschieber PS auf den Beam-blanking-Generator geschaltet wird.

Die am jeweiligen Meßpunkt von den Primärelektronen PE im piezoelektrischen Kristall erzeugten Sekundärelektronen SE treten durch dessen Oberfläche aus und werden über eine Absaugspannung in Richtung des beispielsweise aus Kollektor, Szintillator und Lichtleiter bestehenden Detektors DT beschleunigt. Der im Detektor DT nachweisbare und aufgrund des Potentialkontrasts in seiner Höhe in Abhängigkeit von dem am Meßpunkt anliegenden Potential schwankende Sekundärelektronenstrom wird anschließend eine Auswerteschaltung AS zugeführt. In der Auswerteschaltung AS wird in einem Photomultiplier PM der Sekundärelektronenstrom in ein elektrisches Signal (Potentialkontrastsignal) umgewandelt und in einem nachgeschalteten Vorverstärker VV verstärkt.

Bei diesem Verfahren wird die relativ hohe Frequenz der Oberflächenwelle $f_s$, die im allgemeinen nicht mehr vom Detektor DT übertragen werden kann, mit Hilfe eines mit der Frequenz $f_b$ intensitätsmodulierten Primärelektronenstrahls auf eine niedrigere feste Zwischenfrequenz $f_{if}$ gemischt. Bei niedrigen Frequenzen der Oberflächenwelle $f_s$ kann diese Mischung auch entfallen. Die Frequenz $f_{if}$ des sekundären Elektronensignals ist gleich dem Absolutbetrag der Differenz aus der Frequenz $f_b$ des Primärelektronenstrahls oder einer ihrer Oberschwingungen und der Frequenz der Oberflächenwelle $f_s$ oder einer ihrer Oberschwingungen. Bei der Mischung des Primärelektronenstrahls PE der Frequenz $f_b$ und der Frequenz $f_s$ entsteht ebenfalls ein Signal mit einer Summenfrequenz aus $f_b$ und $f_s$. Dieses Signal wird jedoch aufgrund einer geringeren Bandbreite des Detektors DT im allgemeinen nicht übertragen. Zur Verbesserung des Signal-Rausch-Verhältnisses kann diese Zwischenfrequenz $f_{if}$ mit Hilfe eines Bandpaßfilters BP in der Auswerteschaltung AS, die hinter dem Vorverstärker VV angeschlossen ist, aus dem Sekundärelektronensignal ausgefiltert werden.

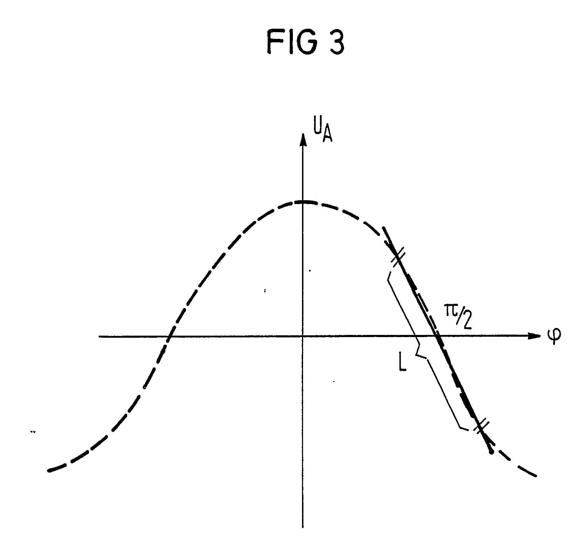

Das Sekundärelektronensignal mit der Frequenz $f_{if}$ weist eine Phase $\rho_3$ auf, gebildet aus der Differenz der Phase der Oberflächenwellen $\rho_2$ und der Phase des Primärelektronenstrahls $\rho_1$. Diese Phasendifferenz wird im Phasendetektor PD, der hinter dem Bandpaß BP angeordnet ist, detektiert. Hierzu benötigt der Phasendetektor PD ein Referenzsignal mit der Frequenz $f_{if}$, das in diesem Falle über einen Frequenzteiler FP aus dem Signal- SG oder Triggergenerator TG gewonnen wird. In Fig. 1 wird hierfür das Synchronisationssignal zwischen dem Signalgenerator SG und dem Triggergenerator TG mit der Frequenz $f_r$ auf den Frequenzteiler FP geschaltet. Als Phasendetektor kommt insbesondere ein Lock-In-Verstärker oder ein phasenempfindlicher Gleichrichter in Betracht. In diesem Fall kann meist auf ein Bandpaßfilter BP verzichtet werden. Um die Phasenmessung mit hoher Empfindlichkeit und Genauigkeit durchführen zu können, wird nun die Phase in der Zwischenfrequenzebene $f_{if}$ am Phasendetektor PD konstant gehalten. Dazu muß man die Phase des Primärelektronenstrahls PE oder aber des elektrischen Signals am Interdigitalwandler IDW entsprechend verändern. Dies geschieht mit Hilfe einer Rückkopplung RK. Das Rückkopplungssignal gewinnt man durch einen Vergleich des Ausgangssignals $U_A$ des Phasendetektors mit einem Sollwert SW in einem Regler R, der hinter dem Phasendeteketor PD geschaltet ist. In der in Fig. 1 angegebenen Realisierung besteht der Regler R aus einem Vergleicher V zum Vergleich des Ausgangssignals $U_A$ des Phasendetektors mit dem Sollwert SW und somit zur Bestimmung der Regeldifferenz und aus einem Regelverstärker RV. Der Sollwert SW sollte dabei so eingestellt werden, daß sich der Arbeitspunkt auf der Kennlinie des Phasendetektors im steilsten Bereich dieser Kennlinie befindet (siehe hierzu auch Figur 3), da man dann die höchste Empfindlichkeit und Genauigkeit erreicht. Die Regeldifferenz wird sodann einem Regelverstärker RV (mit P-oder PI-Verhalten) zugeführt und verändert danach beispielsweise die Phase $\rho$ des Primärelektronenstrahls über einen steuerbaren Phasenschieber PS. Anstelle einer solchen Phasenschiebung kann auch eine Frequenz oder Phasenmodulation des Trigger- TG oder Signalgenerators SG vorgenommen werden, da nur die Phasendifferenz entscheidend ist. Die Stellgröße selbst kann dann als Meßsignal MS herangezogen werden. Das Meßsignal kann allerdings auch -etwas komplizierter - durch Messung der Phasendifferenz des den Primärstrahl PE modulierenden und des den Interdigitalwandler anregenden Signals gewonnen werden. Eine derartige Phasenschiebung bzw. Modulation läßt sich über einen weiten Frequenzbereich mit sehr hoher Genauigkeit durchführen. Dies ist ein wesentlicher Vorteil gegenüber den Verfahren zur Phasenmessung nach dem Stand der Technik.

Da es nur auf die Phasendifferenz ankommt, kann anstelle einer solchen Phasenschiebung auch die Phase des den Interdigitalwandler IDW ansteuernden Signals beeinflußt werden. Dazu ist es möglich, den Phasenschieber PS statt zwischen Triggergenerator TG und Strahlmodulationssystem BBS zwischen Signalgenerator SG und Interdigitalwandler IDW anzuordnen. Beide Möglichkeiten sind gleichwertig. Ebenso ist es möglich, die Phase des Primärstrahls PE zwischen Strahlmodulationssystem und Meßort auf der Probe zu verändern. Schließlich ist es auch möglich, die Phase der dem Phasendetektor PD zugeführten Referenzfrequenz $f_{if}$ mit Hilfe eines Phasenschiebers PS zu verändern. Im Gegensatz zu den zuvor genannten Möglichkeiten läßt sich damit allerdings keine so hohe Genauigkeit erreichen, da die Phasenschiebung bei einer relativ niedrigen Frequenz stattfindet. Andererseits hat die letzte Möglichkeit den Vorzug, daß der Phasenschieber nur auf einer einzigen festen Frequenz $f_{if}$ zu arbeiten braucht. Zur Durchführung der Phasenschiebung ist im übrigen nicht unbedingt ein eigenständiger Phasenschieber erforderlich. Eine Phasenschiebung kann auch durch eine Frequenz- oder Phasenmodulation bewirkt werden. Ebenso ist es möglich, für eine definierte Zeitspanne die Frequenz von Trigger- oder Signalgenerator zu verändern und danach wieder auf den Sollwert zurückzukehren und so eine Phasenschiebung zu erreichen. Dies ist besonders bei computergesteuerten Geräten leicht möglich. Bei einigen kommerziell erhältlichen Generatoren, wie etwa den Modellen hp 8656 und hp 8642 der Firma Hewlett-Packard, ist eine solche Vorrichtung zur Phasenschiebung bereits serienmäßig eingebaut.

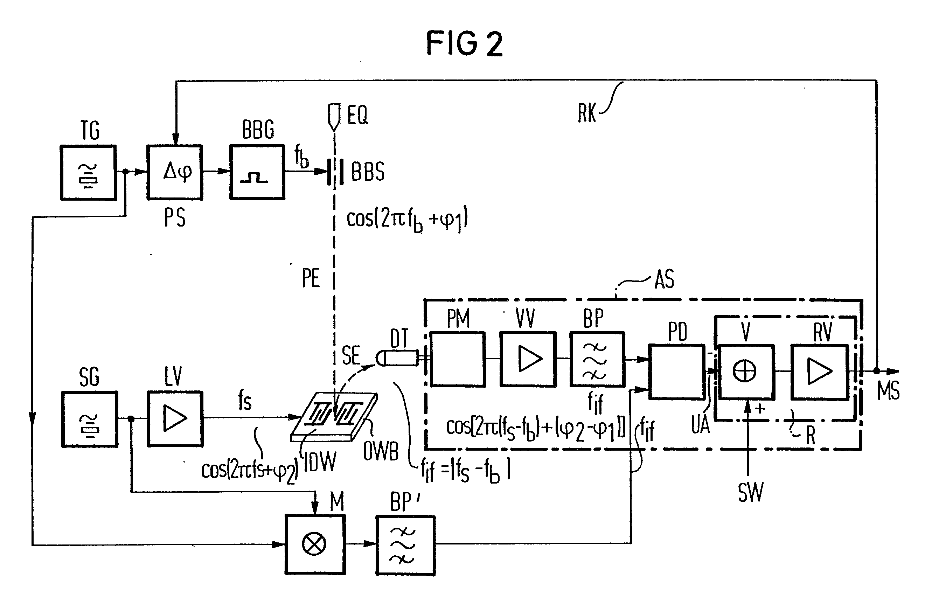

Figur 2 zeigt eine zweite technische Realisierung zur Durchführung des erfindungsgemäßen Verfahrens. Die Schaltung entspricht in wesentlichen Punkten der Schaltung aus Figur 1 und entsprechende Bezugszeichen aus Figur 1 finden hier Verwendung. Während das Referenzsignal der Frequenz $f_{if}$ für den Phasendetektor PD in Figur 1 aus dem Signal- oder Triggergenerator gewonnen wurde, ist in Figur 2 eine weitere Möglichkeit angegeben, dieses Referenzsignal über einen Mischer M mit nachgeschaltetem Tiefpaß oder Bandpaß BP′ zu erzeugen. Die Synchronisationsverbindung zwischen dem Triggergenerator TG und dem Signalgenerator SG kann entfallen, so daß die Mischstufe M mit je einem Eingang mit dem Triggergenerator TG und mit dem Signalgenerator SG verbunden ist. Am Ausgang des nachgeschalteten, auf die Frequenz $f_{if}$ abgestimmten Bandpasses BP′ kann anschließend das Referenzsignal mit der Frequenz $f_{if}$ abgegriffen und dem Phasendetektor PD zugeführt werden.

Figur 3 zeigt die Ausgangskennlinie eines Phasendetektors, in der die Funktion der Ausgangsspannung $U_A$ in Abhängigkeit der Phase $\rho$ dargestellt ist. Wie bereits in Figur 1 angedeutet, besitzen die meisten Phasendetektoren eine Cos $\rho$ - Charakteristik, die sich jedoch in einem Bereich L um den Punkt $\rho = \pi/2$ linearisieren läßt. Innerhalb dieses annähernd linearen Bereiches L ist die Ausgangsspannung proportional zur Phasendifferenz. Zugleich ist dieser Bereich der steilste der Kennlinie. Dort rufen bereits kleine Änderungen der Phasendiffernez größere Änderungen der Ausgangsspannung $U_A$ des Phasendetektors PD hervor. Daher ist in diesem Bereich eine Messung der Phasendifferenz mit sehr hoher Empfindlichkeit und dadurch auch mit großer Genauigkeit möglich.

Aufgabe der Rückkopplung RK in der Vorrichtung nach Figur 1 und Figur 2 ist es, den Arbeitspunkt des Phasendetektors PD innerhalb des linearen Bereichs L konstant zu halten. Außerhalb dieses linearen Bereichs L ist eine Messung der Phase nur noch mit geringer Empfindlichkeit und damit mit recht großen Fehlern möglich.

Die Anregung der Oberflächenwellen muß nicht unbedingt mit einem Interdigitalwandler IDW erfolgen, ebenso ist z.B. auch eine Anregung auf photoakustischem oder elektroakustischem Wege denkbar. Das hier beschriebene Verfahren läßt sich sinngemäß auch auf alle anderen Phasenmessungen mit der Elektronen- oder Lasersonde übertragen.

Die Phasenmessung an Oberflächenwellen mit der Lasersonde hierzu sind beispielsweise in den Veröffentlichungen von H. Engan: IEEE "Transactions on sonics and ultrasonics -29", 1982, auf Seite 281 und IEEE "Transactions on sonics and ultrasonics -25", 1978 auf S. 372 beschrieben, während beispielsweise bereits in den Anmeldungen P 37 25 313.1 (= VPA 87 P 8064 DE) und P 37 25 355.7 (= VPA 87 P 8063 DE) eine Spannungsmessung mit einer Elektronensonde durch Messungen im Frequenzbereich vorgeschlagen wurden, deren Anordnung sich auch zur Phasenmessung nach dem hier beschriebenen Verfahren einsetzen läßt.

Die Mischung auf eine feste Zwischenfrequenz beruht auf einer nicht linearen Schaltkennlinie, hervorgerufen durch das Pulsen des Primärelektronenstrahls. Dies kann man aber ebenfalls erreichen, wenn man anstelle der Primärelektronen die Sekundärelektronen bzw. das Sekundärelektronensignal in ihrer Intensität moduliert. Dies ist beispielsweise möglich, indem man die Energieschwelle eines Gegenfeldspektrometers mit der Frequenz $f_b$ moduliert. Durch Berücksichtigung der Spektrometerkennlinie kann man sogar eine sinusförmige Modulation des Sekundärelektronensignals erreichen, und so eventuelle Schwierigkeiten mit Kreuzmodulationsprodukten, wie sie bei dem beschriebenen Verfahren unter Umständen auftreten, da die Primärelektronen beispielsweise auch mit Rechtecksignalen gepulst werden können, vermeiden. Durch die höheren umzuladenden Kapazitäten und die Energiedispersion der Sekundärelektronen ist die Grenzfrequenz beim Pulsen einer Einrichtung in der Signalverarbeitung geringer. Außerdem wird durch das Spektrometer das Gesichtsfeld eingeschränkt. Analog kann man auch den Photomultiplier zusammen mit einer Gateschaltung betreiben oder im Video-Signalpfad modulieren. In diesem Fall wird die Bandbreite allerdings durch den Szintillator des Detektors stark eingeschränkt.

## Ansprüche

1. Verfahren zur Phasenmessung von Signalen an einem Meßpunkt auf einer Probe, bei dem mindestens ein Punkt der Probenoberfläche durch ein stroboskopisches Verfahren mit Hilfe eines Korpuskularstrahls (PE) abgetastet wird und bei dem an dem jeweils abgetastetem Meßpunkt einer Probenoberfläche auf der Probe (OWB) ein sekundäres elektrisches Signal (SE), insbesondere über einen Detektor (DT) abgeleitet und einer Auswerteschaltung (AS) mit einem Phasendetektor (PD) zugeführt wird, wobei die Frequenz ($f_s$) des Signals mit Hilfe des mit einer einstellbaren Frequenz ($f_b$) intensitätsmodulierten Korpuskularstrahls (PE) gemischt wird, daß dadurch das sich ergebende sekundäre Signal (SE) auf eine bestimmte Zwischenfrequenz ($f_{if}$) gemischt wird, **dadurch gekennzeichnet**, daß die Phase des sekundären elektrischen Signals (SE) mit der festen Zwischenfrequenz ($f_{if}$) am Phasendetektor (PD) konstant gehalten wird.

2. Verfahren zur Phasenmessung nach Anspruch 1, **dadurch gekennzeichnet**, daß das sekundäre elektrische Signal (SE) mit einer festen Zwischenfrequenz ($f_{if}$) in der Auswerteschaltung (AS) ausgefiltert wird.

3. Verfahren zur Phasenmessung nach Anspruch 1 oder 2, **dadurch gekennzeichnet**, daß die Signale an einem Meßpunkt Oberflächenwellen sind.

4. Verfahren zur Phasenmessung nach Anspruch 3, **dadurch gekennzeichnet**, daß die Signale Oberflächenwellen auf piezoelektrischen Substraten sind, bei dem man auf der Oberfläche einer piezoelektrische Eigenschaften aufweisenden Probe Oberflächenwellen anregt und bei dem man das die Oberfläche begleitende lokale elektrische Feld an mindestens einem Punkt der Probenoberfläche durch das stroboskopische Verfahren mit Hilfe des Korpuskularstrahls (PE) abtastet.

5. Verfahren nach einem der Ansprüche 1 bis 4, **dadurch gekennzeichnet**, daß die Phase des sekundären elektrischen Signals (SE) mit einer festen Zwischenfrequenz ($f_{if}$) im steilsten Abschnitt (L) einer Ausgangskennlinie des Phasendetektors (PD) konstant gehalten wird.

6. Verfahren nach einem der Ansprüche 1 bis 5, **dadurch gekennzeichnet**, daß die Phase des sekundären elektrischen Signals (SE) mit einer festen Zwischenfrequenz ($f_{if}$) über eine Rückkopplung geregelt wird, daß ein Rückkopplungssignal mit einem Vergleich eines Ausgangssignals ($U_A$) des Phasendetektors mit einem vorgegebenen Sollwert (SW) gewonnen wird, daß das Rückkopplungssignal die Phase des intentsitätsmodulierten Korpuskularstrahls (PE) so beeinflußt, daß die Phasendifferenz, gebildet aus der Differenz der Phase des intensitätsmodulierten Korpuskularstrahls (PE) und der Phase des Signals am Phasendetektor (PD) konstant bleibt.

7. Verfahren nach einem der Ansprüche 1 bis 5, **dadurch gekennzeichnet**, daß die Phase des sekundären elektrischen Signals (SE) mit einer festen Zwischenfrequenz ($f_{if}$) über eine Rückkopplung geregelt wird, daß ein Rückkopplungsignal aus einem Vergleich eines Ausgangssignals $(U_A)$ des Phasendetektors mit einem vorgegebenen Sollwert (SW) gewonnen wird, daß das Rückkopplungssignal die Phase des Signals so beeinflußt, daß die Phasendifferenz, gebildet aus der Differenz der Phase des intensitätsmodulierten Korpuskularstrahls (PE) und der Phase des Signals, am Phasendetektor (PD) konstant bleibt.

8. Verfahren nach einem der Ansprüche 1 bis 5. **dadurch gekennzeichnet,** daß die Phase des sekundären elektrischen Signals (SE) mit einer festen Zwischenfrequenz $(f_{if})$ über eine Rückkopplung geregelt wird, daß ein Rückkopplungssignal aus einem Vergleich eines Ausgangssignals $(U_A)$ des Phasendetektors mit einem vorgegebenen Sollwert (SW) gewonnen wird, daß das Rückkopplungssignal die Phase eines Referenzsignals mit einer Zwischenfrequenz $(f_{if})$ für den Phasendetektor (PD) so beeinflußt, daß die Phasendifferenz, gebildet aus der Differenz der Phase des intensitätsmodulierten Korpuskularstrahls (PE) und der Phase des Signals am Phasendetektor (PD) konstant bleibt.

9. Verfahren nach einem der Ansprüche 1 bis 8. **dadurch gekennzeichnet,** daß Amplitude, Frequenz $(f_s)$ und Phase einer auf der Probenoberfläche angeregten Oberflächenwelle über das elektrische Eingangssignale einer der Oberflächenwellen erzeugenden Vorrichtung (IDW) eingestellt wird.

10. Vorrichtung zur Phasenmessung von Signalen an einem Meßpunkt mit einem Korpuskularstrahlerzeuger (EQ), mit Mitteln zur Fokussierung, Ablenkung und Positionierung des Korpuskularstrahls (PE) auf einer Probe (OWB) mit Mitteln (BBS) zur Intensitätsmodulation des Korpuskularstrahls (PE), oder zur Intensitätsmodulation des sekundären Signals (SE) mit einer Signalkette zur Umwandlung eines an einem Meßpunkt der Probenoberfläche abgeleiteten sekundären Signals (SE), wobei die Signalkette insbesondere eine Auswerteschaltung (AS) aufweist, wobei die Auswerteschaltung (AS) einen Phasendetektor (PD) enthält, und daß dem Phasendetektor (PD) ein Referenzsignal mit der Zwischenfrequenz $(f_{if})$ und ein umgewandeltes elektrisches sekundäres Signal insbesondere über Teilen der Auswerteschaltung (AS) zugeführt wird, wobei die Mittel (BBS) zur Intensitätsmodulation des Korpuskularstrahls (PE) oder des sekundären Signals (SE) über einen Generator (BBG) zur Intensitätsmodulation des Korpuskularstrahls an einen Triggergenerator (TG) angeschlossen sind, **dadurch gekennzeichnet,** daß ein Regler (R) mit einem ersten Eingang am Ausgang des Phasendetektors (PD) angeschlossen ist, auf einem zweiten Eingang des Reglers (R) ein Sollwert (SW) aufgeschaltet ist, daß ein Ausgang des Reglers (R) ein Meßsignal (MS) liefert.

11. Vorrichtung zur Phasenmessung nach Anspruch 10. **dadurch gekennzeichnet,** daß die Probe (OWB) mit einem Signalgenerator (SG) verbunden ist zur Ansteuerung der Probe (OWB) mit Signalen.

12. Vorrichtung zur Phasenmessung nach Anspruch 10. **dadurch gekennzeichnet,** daß die Signale Oberflächenwellen sind, daß eine Vorrichtung (IDW) zur Erzeugung von Oberflächenwellen über einen Leistungsverstärker (LV) an einen Signalgenerator (SG) angeschlossen ist.

13. Vorrichtung nach einem der Ansprüche 10 bis 12. **dadurch gekennzeichnet,** daß die Signalkette einen Detektor (DT) enthält, zur Detektion des sekundären elektrischen Signals (SE).

14. Vorrichtung nach einem der Ansprüche 10 bis 13. **dadurch gekennzeichnet,** daß der Regler (R) einen Vergleicher (V) zum Vergleich des Ausgangsignals $(U_A)$ des Phasendetektors (PD) mit dem Sollwert (SW) und einen nachgeschalteten Regelverstärker (RV) enthält.

15. Vorrichtung nach einem der Ansprüche 10 bis 14. **dadurch gekennzeichnet,** daß ein Phasenschieber (PS) zwischen Triggergenerator (TG) und dem Generator (BBG) zum Austasten des Korpuskularstrahls geschaltet ist, daß ein Ausgang des Reglers (R) mit dem Phasenschieber (PS) über eine Rückkopplung (RK) verschaltet ist.

16. Vorrichtung nach einem der Ansprüche 10 bis 14. **dadurch gekennzeichnet,** daß ein Phasenschieber (PS) zwischen einem Frequenzteiler (FP), der ein Referenzsignal mit der Zwischenfrequenz liefert und einen Eingang des Phasendetektors (PD) geschaltet ist, daß ein Ausgang des Reglers (R) mit dem Phasenschieber (PS) über eine Rückkopplung (RK) verschaltet ist.

17. Vorrichtung nach einem der Ansprüche 10 bis 14. **dadurch gekennzeichnet,** daß ein Ausgang des Reglers (R) mit dem Triggergenerator (TG) über eine Rückkopplungsschaltung (RK) verschaltet ist.

18. Vorrichtung nach einem der Ansprüche 10 bis 14. **dadurch gekennzeichnet,** daß ein Ausgang des Reglers (R) über eine Rückkopplungsleitung (RK) mit dem Signalgenerator (SG) verschaltet ist.

19. Vorrichtung nach einem der Ansprüche 10 bis 18. **dadurch gekennzeichnet,** daß der Triggergenerator (TG) für Synchronisationszwecke mit dem Signalgenerator (SG) und ein Frequenzteiler (FP) mit einem von beiden verbunden ist, daß der Frequenzteiler (FP) ein Referenzsignal mit der Zwischenfrequenz $(f_{if})$ liefert.

20. Vorrichtung nach einem der Ansprüche 10 bis 18. **dadurch gekennzeichnet,** daß der Triggergenerator (TG) und der Signalgenerator (SG) mit jeweils einem Eingang einer Mischstufe (M) und nachgeschaltetem Filter (BP') verbunden sind, daß ein Filterausgang ein Referenzsignal der Zwischenfrequenz (f$_{if}$) liefert.

21. Vorrichtung nach einem der Ansprüche 10 bis 20, **dadurch gekennzeichnet,** daß die Auswerteschaltung (AS) einen Photomultiplier (PM) mit nachgeschaltetem Vorverstärker (VV) und einem Bandpaßfilter (BP) enthält.

22. Vorrichtung nach einem der Ansprüche 10 bis 21, **dadurch gekennzeichnet,** daß die Oberflächenwellen mit Hilfe eines Interdigitalwandlers (IDW) erzeugt werden.

23. Vorrichtung nach einem der Ansprüche 10 bis 21, **dadurch gekennzeichnet,** daß die Oberflächenwellen mit Hilfe eines Lasers angeregt werden.

24. Vorrichtung nach einem der Ansprüche 10 bis 21, **dadurch gekennzeichnet,** daß die Oberflächenwellen mit Hilfe eines intensitätsmodulierten Elektronenstrahl angeregt werden.

25. Vorrichtung nach einem der Ansprüche 10 bis 24, **dadurch gekennzeichnet,** daß der Phasendetektor (PD) ein Lock-In-Verstärker ist.

FIG 1

# FIG 2

EP 0 308 677 A1

TG

BBG

EQ

RK

$\Delta\varphi$

$f_b$

BBS

PS

$\cos(2\pi f_b + \varphi_1)$

PE

AS

PM    VV    BP

PD

V    RV

SG    LV

$f_s$

DT

SE

$f_{if}$

MS

$\cos(2\pi f_s + \varphi_2)$

IDW

OWB

$\cos[2\pi(f_s - f_b) + (\varphi_2 - \varphi_1)]$

$f_{if}$

UA

R

$f_{if} = |f_s - f_b|$

SW

M

BP'

# FIG 3

## EINSCHLÄGIGE DOKUMENTE

| Kategorie | Kennzeichnung des Dokuments mit Angabe, soweit erforderlich, der maßgeblichen Teile | Betrifft Anspruch | KLASSIFIKATION DER ANMELDUNG (Int. Cl.4) |
|---|---|---|---|
| D,Y | SCANNING ELECTRON MICROSCOPY, 1983, Seiten 55-63, SEM Inc. AMF O'Hare, Chigago, US; H.P. FEUERBAUM et al.: "Examination of surface acoustic wave components using a scanning electron microscope" * Seite 57, linke Spalte, 2. Absatz - Seite 59, rechte Spalte, 1. Absatz; Figuren 9,12 * | 10-13, 16,22 | G 01 R 25/04 |
| D,A | IDEM.<br>--- | 1,3,4,9 | |
| Y | DE-A-1 813 188 (AGA) * Seite 1, letzter Absatz - Seite 2, 1. Absatz; Seite 5, letzter Absatz - Seite 7, 1. Absatz; Seite 7, letzter Absatz; Figur 3 * | 10-13, 16,22 | |
| A | <br>--- | 1,2,6-8 | |
| A | DE-A-2 354 146 (SIEMENS) * Seite 3, 4. Absatz - Seite 4, 1. Absatz; Figuren 1,2 *<br>--- | 1,6-8, 10,14 | **RECHERCHIERTE SACHGEBIETE (Int. Cl.4)** |
| D,A | JAPANESE JOURNAL OF APPLIED PHYSICS, Band 23, 1984, Supplement 23-1, Seiten 191-193, Tokyo, JP; K. YAMANOUCHI et al.: "Excitation of surface acoustic waves using electron acoustic microscope" * Seite 191, erster Absatz; Figur 1 *<br>----- | 23,24 | G 01 R<br>H 03 D |

Der vorliegende Recherchenbericht wurde für alle Patentansprüche erstellt

| Recherchenort | Abschlußdatum der Recherche | Prüfer |
|---|---|---|
| DEN HAAG | 08-12-1988 | WIEMANN L. |